# EUROPEAN PATENT APPLICATION

(11) **EP 3 086 128 A1**
(43) Date of publication of application: **26.10.2016**
(21) Application number: 16163929.9
(22) Date of filing: 05.04.2016
(51) Int. Cl.: G01R 15/18, G01R 31/02

(54) **MULTIPLE COIL CONFIGURATION FOR FAULTED CIRCUIT INDICATOR**

(30) Priority: 22.04.2015 US 201562150878 P
(71) Applicant: Thomas & Betts International LLC, Wilmington, DE 19809 (US)
(72) Inventor: DODDS, William J., Hackettstown, NJ New Jersey 07840 (US); KHOSHNOOD, Bahman, Boca Raton, FL Florida 33498 (US); MARTIN, David, Okeechobee, FL Florida 34972 (US)
(74) Representative: Carpmaels & Ransford LLP

(57) **Abstract**

A faulted circuit indicator, FCI, may use a multiple coil configuration to improve measurements of current flowing through a power line. The FCI may include a fault alert module (255) and a sensor (210) configured to measure a current flowing within a power line based on a first inductive coupling with the power line. The FCI may further include a power supply (285) configured to provide at least one supply voltage based on a second inductive coupling with the power line. The FCI may include a detector/controller module (235) coupled to the fault alert module (255), sensor (210), and power supply (285). The detector/controller (235) may be configured to monitor measurements provided by the sensor (210), and provide a warning signal to the fault alert module (255) when a fault condition in the power line is detected.

## Description

### BACKGROUND OF THE INVENTION

Faulted circuit indicators (FCIs) may be attached to power lines and used to detect electrical faults in power distribution systems. The FCI may detect anomalies in the current and/or voltage of the power line waveform, and provide an indication of fault to technicians working to isolate the location of a malfunction in the power distribution system. The indication of a detected fault may be provided by an on-board fault indicator (e.g., in a visual manner using a mechanical indicator (e.g., a "flag") and/or a blinking Light Emitting Diode (LED), and/or by communications interface over a network (e.g., over a cellular network).

Conventional FCIs rely on a single coil to inductively monitor faults and generate power through a magnetic field produced by the power line. However, a single coil configuration can involve design tradeoffs between power efficiency and measurement accuracy. Such tradeoffs may prevent the realization of a single FCI that can accurately measure the current flowing though the power line while efficiently supplying power to componentry therein. Thus, in order to meet varying customer requirements regarding monitoring accuracy and power efficiency, conventional FCIs may be produced in multiple versions. Each version will use only a single coil with differing parameters in order to separately emphasize either accuracy or efficiency requirements, depending upon the application. The production and support of multiple versions of FCIs can increase both the cost and complexity of manufacturing and maintenance.

### BRIEF DESCRIPTION OF THE DRAWINGS

Fig. 1 is an illustration of an exemplary environment implementing faulted circuit indicators (FCIs) that use a multiple coil configuration;
Fig. 2 is a block diagram depicting exemplary components for an FCI having a multiple coil configuration according to an embodiment;
Fig. 3 is a perspective diagram of a coil assembly that includes a sensing coil and a power coil according to an embodiment;
Figs 4A-4C are a perspective diagrams illustrating various details of an exemplary sensing coil;
Fig. 5 is a perspective diagram illustrating an embodiment of a coil assembly module in relation to a power line;
Fig. 6 is a perspective diagram illustrating another embodiment of the coil assembly module that includes a hinged laminate component; and
Fig. 7 is a flow chart showing an exemplary process for monitoring a current flow within a power line according to an embodiment.

### DETAILED DESCRIPTION OF EMBODIMENTS

The following detailed description refers to the accompanying drawings. The same reference numbers in different drawings may identify the same or similar elements.

Embodiments described herein are directed to faulted circuit indicators (FCIs) that include distinct coils that may be dedicated to either the accurate measurement of current or the efficient supply of power. For example, in an embodiment, an FCI may include a sensing coil and a power coil. The sensing coil may be designed with an emphasis for accurately measuring the current in a power line. The power coil may be designed with an emphasis for efficiently generating a supply voltage to power the components for the operation of the FCI. While the separate coils may include some degree of magnetic coupling, embodiments herein may electrically isolate the sensing coil from the power coil to improve the accuracy of the current measurements.

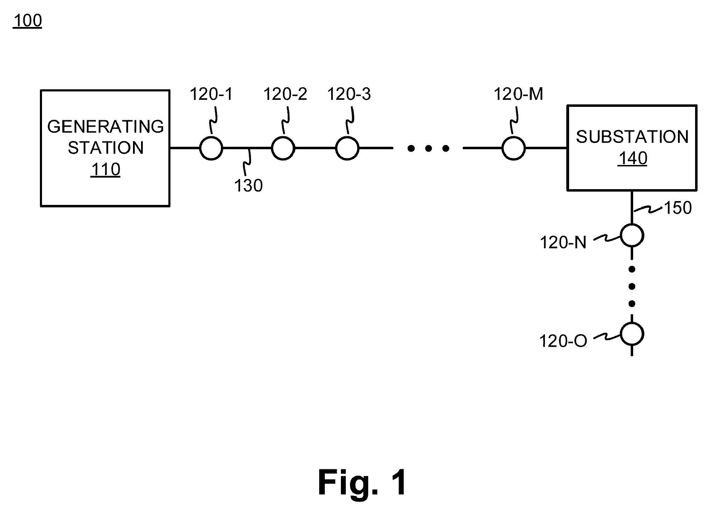

Fig. 1 is an illustration of an exemplary power distribution environment 100 that may use one or more faulted circuit indicators (FCIs) having a multiple coil configuration. Power distribution environment may use one or more FCIs that have a multiple coil configuration for measuring current and generating a supply voltage. Power distribution environment 100 may include a generating station 110, a plurality of FCIs 120 (herein referred to collectively as "FCIs 120" and individually as FCI 120-x"), a transmission line 130, a substation 140, and a distribution line 150. Power distribution environment 100 may be part of a larger power distribution system, and may include additional or different entities in alternative configurations than which are exemplified in Fig. 1.

Generating station 110 may transmit power on transmission lines 130 over long distances, which may terminate substation 140. High voltages, e.g., 66 kV and above (e.g., 110 kV), may be employed in transmission lines 130 to improve efficiencies of the delivery of electric power. Accordingly, for safety reasons, transmission lines 130 may be suspended high off the ground using transmission towers. FCIs 120-1 through 120-M may be mounted directly on transmission lines 130 using spacing consistent with conventional power monitoring systems, and, in some embodiments, at distances that permit radio communications at least between adjacent FCIs 120. While the spacing shown in Fig. 1 between FCIs 120 appears to be the same, the lengths between adjacent FCIs 120 do not have to be the equidistant. Given the height of transmission lines 130 and the magnitude of the voltages being transferred, access to FCIs 120-1 through 120-M for maintenance, such as battery replacement, can be difficult and hazardous. As such, it can be desirable so minimize the maintenance each FCI 120 requires. Transmission lines 130 may terminate at substation 140, which may step-down the high voltage provided over transmission lines 130 for distribution to various classes of customers, such as, for example, sub-transmission customers, primary customers, and/or secondary customers (such as, for example, homes and small businesses). Accordingly, distribution lines 150 may employ lower voltages, ranging from 33 kV to 66 kV. Distribution lines 150 leading from substation 140 may also be monitored with a plurality of FCIs 120-N through 120-O, that may be suspended directly from distribution lines 150. As used herein, the term "power line" may be used to designate any type of conducting line used to transmit power. Accordingly, both transmission line 130 and distribution line 150 may be referred to as "power lines."

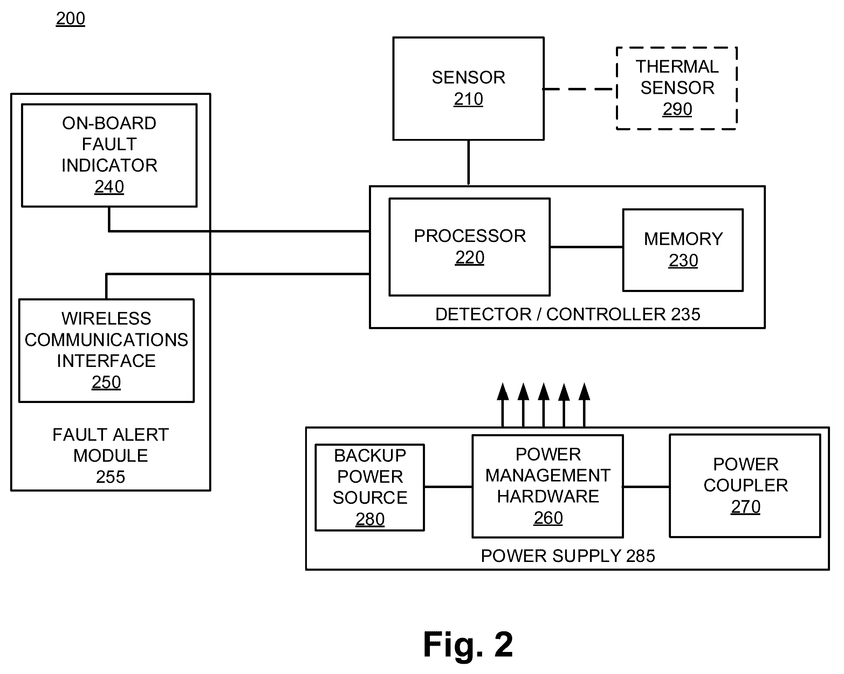

FCIs 120 may be used to locate earth-faults or short-circuits in a power distribution system. Each of FCIs 120 may constantly monitor the power line for earth-fault and/or short-circuit conditions. As soon as a fault current higher than the trip value is detected, the fault will be indicated. To avoid false indications, FCIs 120 may sample and analyze the measured signal using, for example, a processor as will be explained in more detail in relation to Fig. 2.

Fig. 2 is a block diagram depicting exemplary components for an FCI 200 having a multiple coil configuration according to an embodiment. FCI 200 may include a sensor 210, detector/controller 235, a fault alert module 255, and a power supply 285. In an embodiment, FCI 200 may optionally include a thermal sensor 290, which is shown in Fig. 2 using dashed lines to indicate the optionality thereof.

Sensor 210 may be configured to measure a current flowing within a power line (which may be referred to herein as the "power line current") based on an inductive coupling, and provide a signal representative of the measurement. The inductive coupling may be formed by placing sensor 210 (or a portion thereof) in proximity to the power line for receiving an exposure to a magnetic field produced by the power line current. In response to the magnetic field, sensor 210 can generate the signal containing information that measures the power line current by characterizing one or more parameters thereof (e.g., amplitude, phase, etc.). The signal produced by sensor 210 may be based on a dedicated sensing transducer that generates a measurement voltage in response to the magnetic field produced by the power line. The signal may be provided to detector/controller 235 that may monitor the signal to detect fault conditions within the power line. In an embodiment, faults may be detected based on variations observed in the signal that indicates that the power line current appears out of specification and/or is experiencing an anomalous condition preventing proper operation (e.g., an open circuit, overvoltage, etc.).

Once detector/controller 235 determines a fault condition exists, a warning signal may be provided to fault alert module 255 by detector/controller 235. Fault alert module 255, based on the warning signal received, may trigger an on-board fault indicator 240 to provide an indication of the fault condition that may be observed by a technician in the vicinity of the FCI 200. Additionally or alternatively, fault alert module 255 may trigger a wireless communications interface 250 to provide a warning message(s) for transmission over a wireless network. In an embodiment, the warning message(s) may be received either by a gateway at generating station 110 and/or substation 140, and may be forwarded to mobile devices carried by technicians in the field. Additionally or alternatively the warning messages(s) may be sent directly to the mobile devices of the field technicians using an ad-hoc network if the mobile devices are outside the range of a pre-established network. In some embodiments, fault alert module 255 may not include wireless communications interface 250, thus the warning signal provided by detector/controller 235 may only be used to trigger an indication of the fault (e.g., a visual indication) generated by on-board fault indicator 240.

In order for FCI 200 to perform the aforementioned functionality, power supply module 285 may provide one or more supply voltages to sensor 210, detector controller 235, fault alert module 255, and/or thermal sensor 290. Power supply module 285 may generate the supply voltages(s) based on a dedicated power transducer that generates a primary supply voltage in response to the magnetic field produced by the power line.

Sensor 210 may include a dedicated transducer to sense the power line current based on an inductive coupling with the power line. Sensor 210 may further include additional electronics and/or processors for providing a signal characterizing (i.e., "measuring") the power line current. The signal may measurements of one or more parameters characterizing the power line current, including, for example, amplitude, frequency, phase, power factor, and/or the direction of flow within the power line.

In one embodiment, the dedicated transducer may be realized as a sensing coil that can be arranged around a laminate core. The sensing coil can be designed to generate a clean (e.g., low noise) and accurate measurement voltage upon exposure to the magnetic field produced by the power line current. To this end, the sensing coil and/or the laminate core may be electrically isolated from other components in FCI 200 to prevent corrupting the measurement voltage with noise. For example, the sensing coil and/or its laminate core may be electrically isolated from subcomponents in power supply 285 that may include a power coil and/or other power electronics used therein.

Once the measurement voltage has been generated by the sensing coil, sensor 210 may include additional electronics and/or processor(s) to perform signal processing on measurement voltage to reduce noise, improve accuracy, and/or facilitate interface with detector/controller 235. For example, the measurement voltage may be filtered, calibrated, and/or amplified so that the signal provided to detector/controller 235 represents a better measurement of the power line current. In one embodiment, the signal provided from sensor 210 to detector/controller 235 may be an analog signal. Alternatively, sensor 210 may include an analog-to-digital converter and other interfacing circuitry so as to provide a digital signal to detector/controller 235. Additionally, once the measurement voltage is in the digital domain, sensor 210 may additionally perform digital signal processing operations to improve the accuracy of the output signal.

In another embodiment, sensor 210 may simply provide the measurement voltage from the coil, or an amplified version thereof, to detector/controller 235 as the signal, and let detector/controller perform analog-to-digital conversion and signal processing operations (analog and/or digital) to improve the quality of the measured voltage, and thus more accurately reflect the power line current.

Optionally, temperature compensation may be performed on the measurement voltage using temperatures provided by thermal sensor 290. In one embodiment, as shown in Fig. 2, temperature compensation may be performed within sensor 210, which may directly receive temperature data from thermal sensor 290. Alternatively, thermal sensor 290 may provide temperature values to the detector/controller 235, which can perform temperature compensation after receiving the signal from the sensor 210. In order to obtain an accurate measurement of the power line current, the sensing coil in sensor 210 may be placed proximally to the power line in relation to other components in FCI 200, such as, for example, a coil residing in power supply 285 that generates a primary voltage, as will be described in more detail below.

Detector/controller 235 may control the components in FCI 200 and provide processing to detect fault conditions occurring within the power line. In an embodiment, detector controller 235 may include a processor 220 and memory 230. Processor 220 may be coupled to memory 230, which may store instructions to configure processor 220 to receive, from sensor 210, the measurements of current flowing through the power line in the form of the signal. Processor 220 may identify variations in the received measurements of current, and determine whether the identified variations are indicative of a fault condition. Processor 220 may generate and provide a warning signal to fault alert module 255 upon determining that the identified variations are indicative of the fault condition. Processor 220 may include a processor, microprocessor, or processing logic that may interpret and execute instructions. Alternatively, processor 220 may include dedicated hardware, such as an ASIC, for performing logical and/or mathematical operations. Processor 220 may interface to other components using a bus (not shown) or through other interfaces that may be dedicated to particular on-board devices. Memory 230 may include a random access memory (RAM), read only memory (ROM), and/or any other type of storage device that may store information and instructions for execution by microcontroller 430. Memory 230 may be integrated with processor 220 in a common package, or may be housed externally, or a combination thereof. In alternate embodiments, dedicated hardware circuits, including analog and/or digital circuitry, may be used to perform detection and/or control operations for FCI 200.

Power supply 285 may include power management hardware 260, a power coupler 270, and a backup power source. Power coupler 270 may include a dedicated transducer that may generate a primary supply voltage based on an inductive coupling with the power line. In an embodiment, the transducer may be a power coil that may be wound around a laminate structure and generate the primary supply voltage upon exposure to the magnetic field produced by the current flowing through the power line. Power coupler 270 may perform some power conditioning operations (e.g., filtering) and provide the primary supply voltage to power management hardware 260, that may convert the primary supply voltage into one or more supply voltages suitable for use by the components within FCI 200. For example, power management hardware 260 may condition the primary supply voltage to remove surges and/or spikes, and produce one or more DC supply voltage(s) suitable to power the electronic components in FCI 200.

Backup power source 280 may be used to power the other components in FCI 200 when no power line signal is present, or as an additional source of power if needed. FCI 200 may inductively draw power from the power line during normal operations, which may power the initial components and also, in some implementations, charge backup power source 280. The backup power source may include one or more types of rechargeable or non-rechargeable energy storage devices (e.g., batteries).

Fault alert module 255 may include on-board fault indicator 240 and/or wireless communications interface 250. Fault alert module 255 may receive one or more type of signals from detector/controller 235 which include a warning signal indicating a fault condition has been detected by detector/controller 235. The warning signal may be used to trigger the generation and transmission of a message by wireless communications interface 250 over a wireless network. Additionally, wireless communications interface 250 may be used to exchange information with other network elements on a wireless network, to transmit status and/or other messages, and/or receive data and/or software updates. Additionally or alternatively, embodiments may also use the warning signal provided by the detector/controller 235 to trigger a visual fault indication using on-board fault indicator 240.

Wireless communication interface 250 may also communicate with other FCIs 200 and/or directly with a gateway over one or more wireless channels. FCIs 200 may operate in full duplex mode, thus having multiple channels that use frequency division multiplexing and/or code division multiplexing, for example, to avoid cross talk interference. The type of wireless channel may depend on the environment in which FCIs 200 are operating. In an embodiment, where FCIs 200 are coupled to power lines 210 that are suspended from transmission towers, communications interface 270 may be based on any suitable wireless communication, in including wireless local area networking (e.g., RF, infrared, and/or visual optics, etc.) and/or wireless wide area networking (e.g., WiMaxx, cellular technologies including GPRS, 3G, HSxPA, HSPA+, LTE, etc.). Wireless communication interface 250 may include a transmitter that converts baseband signals to RF signals and/or a receiver that converts RF signals to baseband signals. Wireless communication interface 250 may be coupled to one or more antennas for transmitting and receiving RF signals. In other environments, wireless communications interface 250 may rely on wireless communications based low frequency electromagnetic carriers and/or acoustic carriers (for penetrating ground and/or water), and have the appropriate hardware and transducers for transmitting and receiving over a range of frequencies and/or waveform types (electromagnetic and/or acoustic).

On-board fault indicator 240 may include conventional fault indicators, such as, for example, electromagnetically triggered flags, and/or LED indicators. Having conventional indictors in addition to those provided over the wireless channels may be useful when technicians are trouble-shooting the power distribution system in the field.

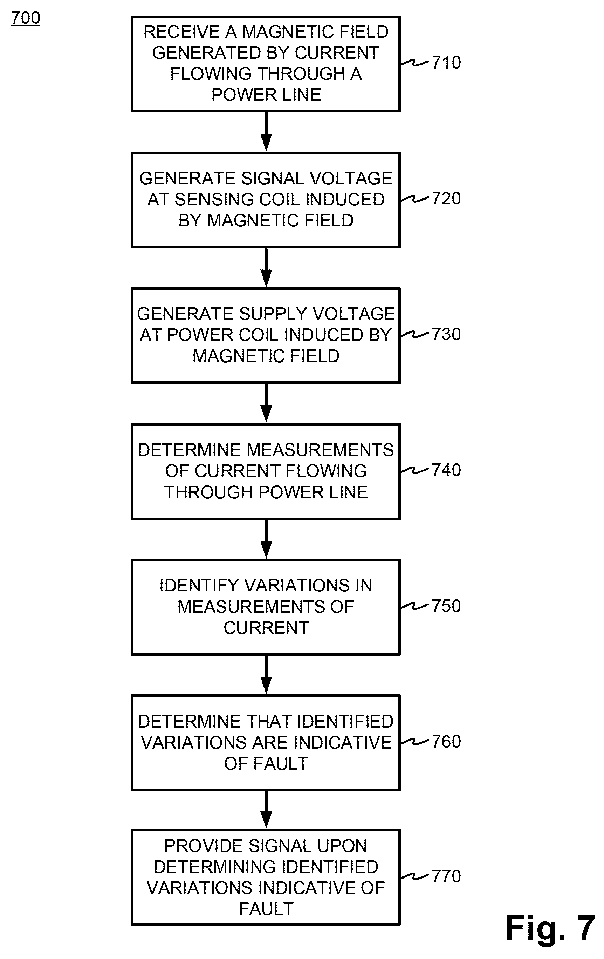

FCIs 200 may perform certain operations or processes, as may be described below in relation to Fig. 7. FCI 200 may perform a subset of these operations in response to processor 220 executing software instructions contained in a computer-readable medium, such as memory 230. A computer-readable medium may be defined as a physical or logical memory device. A logical memory device may include memory space within a single physical memory device or spread across multiple physical memory devices. The software instructions may be read into memory 230 from another computer-readable medium or from another device via fault alert module 255. The software instructions contained in memory 230 may cause processor 220 to perform one or more of the operations or processes that will be described in detail with respect to Fig. 7. Alternatively, hardwired circuitry may be used in place of or in combination with software instructions to implement processes consistent with the principles of the embodiments. Thus, exemplary implementations are not limited to any specific combination of hardware circuitry and software.

The configuration of components of FCI 200 illustrated in Fig. 2 is for illustrative purposes only. It should be understood that other configurations may be implemented. Therefore, FCI 200 may include additional, fewer and/or different components than those depicted in Fig. 2. Additionally, Fig. 2 illustrates an exemplary FCI 200 primarily from a functional perspective for the purposes of explanation, and the actual physical placement of hardware components in a realized FCI 200 may differ than the components shown in Fig. 2.

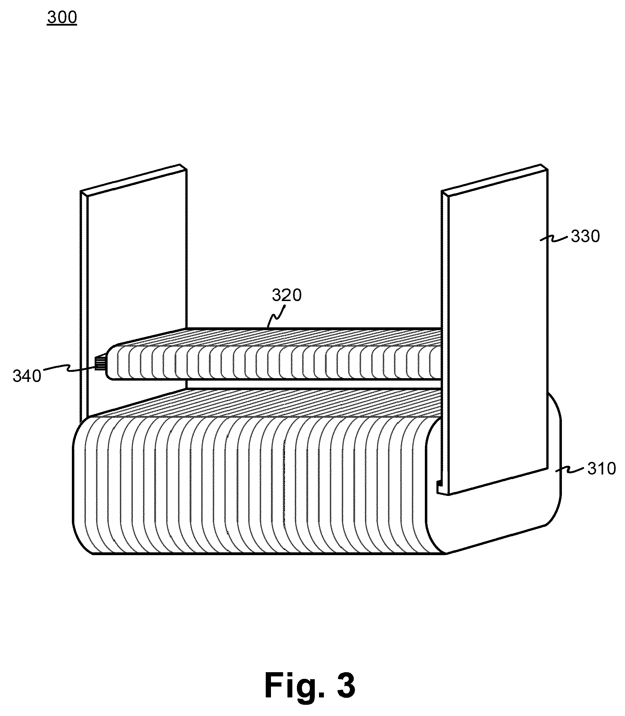

Fig. 3 is a perspective diagram of a coil assembly 300 according to an embodiment. The coil assembly 300 may include a power coil 310, a sensing coil 320, a laminate structure 330, and laminate core 340.

The power coil 310 may include windings of wire wound around a portion of laminate structure 330, and sensing coil 320 may include separate windings wound around separate laminate core 340. Power coil 310 may have a larger number of windings than sensing coil 320. For example, power coil 310 may have a number of winding that exceeds 10,000. Sensing coil 320 may have a number of windings that exceeds 100. The design and placement of power coil 310 may facilitate the efficient generation of a primary supply voltage upon exposure to a magnetic field produced by the power line current. The material for power coil 310 and/or sensing coil 320 may be a solid wire or a branded wire made from a highly conductive material such as copper or aluminum (where aluminum may be used if weight is a concern). Alternatively, various alloys of copper and/or aluminum may be used depending upon the application. The wire comprising the winding may be coated with an enamel as an insulator to prevent short circuits.

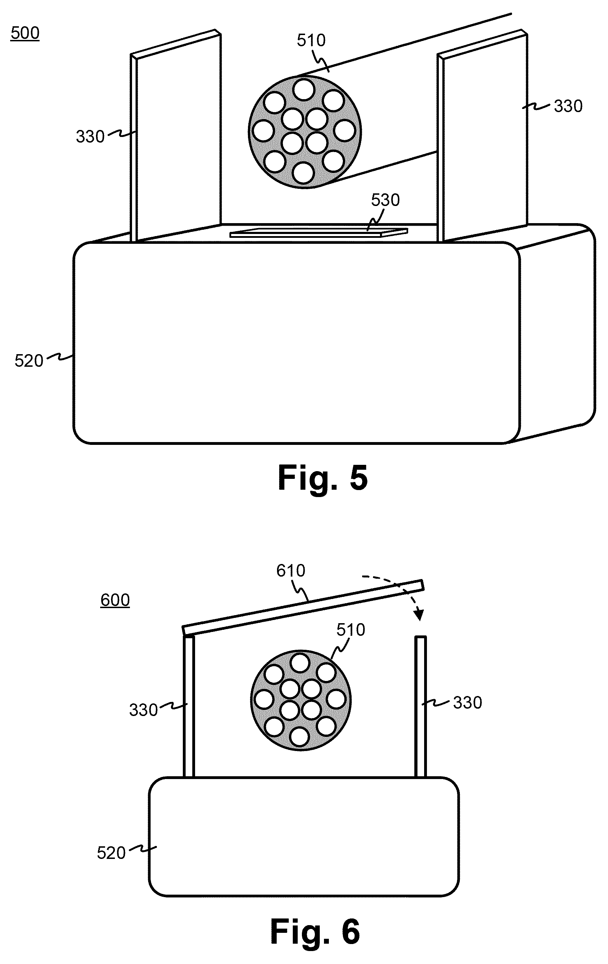

Laminate structure 330 may be generally configured in a "U" shape, and can have power coil 310 wound around the lower portion of the "U" shape as shown in Fig. 3. Sensing coil 320 may be placed within "legs" of the "U" shape laminate structure 330 in order to be in close proximity to the power line. Additionally, the legs of laminate structure 330 may be used to partially confine the power line (as shown in Fig. 5) for facilitating the placement of sensing coil 320 in order to support quality measurements of the power line current by generating a measurement voltage having, for example, low and minimal interference that may accurately characterize the power line current.

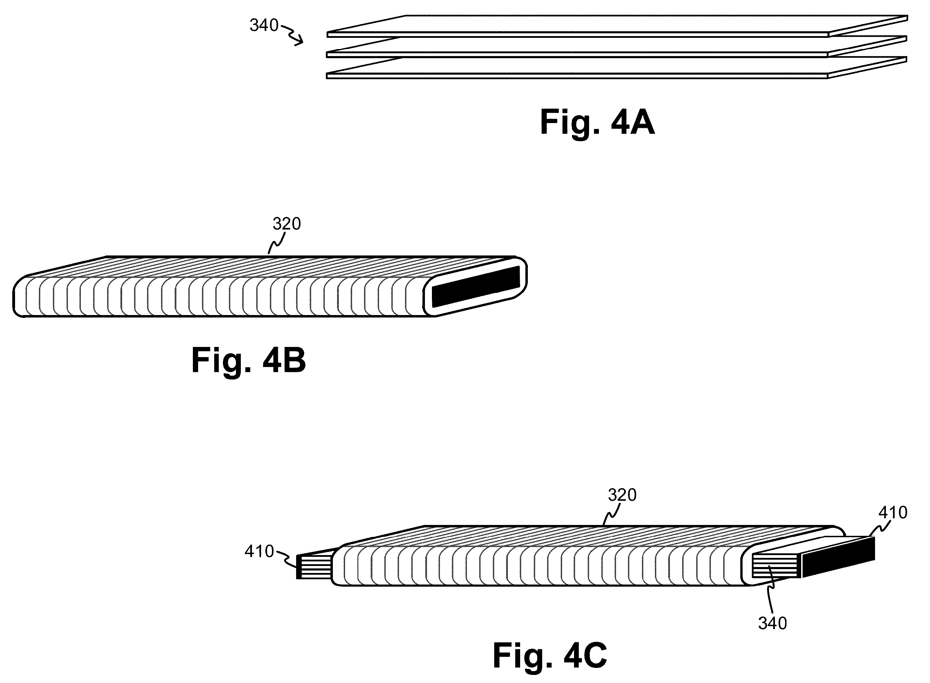

The laminate structure 330 may include a plurality of metal layers insulated from each other using a coating to reduce eddy currents. The metal layers may be iron or alloys thereof that may include Nickle, Molybdenum, and/or other suitable elements. Sensing coil 320 and laminate core 340 will discussed in more detail below in relation to Fig. 4.

Laminate core 340 may be electrically insulated from power coil 310 and laminate structure 330. However, in some embodiments, sensing coil 320 and power coil 310 may be magnetically coupled while being electrically isolated. In other embodiments, sensing coil 320 and power coil 310 may also be magnetically isolated by using magnetic shielding (e.g., ferrous and/or laminate barrier between sensing coil 320 and power coil 310) and/or by using a different physical configuration of the coils than what is shown in Fig 3. For example, the coils could be placed on opposite sides of the power line in a laminate structure that may surround the power line, such as, for example, a coil assembly using a laminate structure similar to the example shown in Fig. 6, where one of the coils (presumably the smaller signal coil) may be placed on a pivoting member of the laminate structure (e.g., 610 of Fig. 6).

While in the aforementioned description, coil assembly 300 is used in the context of power line applications where sensing coil 320 measures power line current, it should be appreciated that coil assembly 300 is not limited to such applications. For example, coil assembly may be used in other settings where it is desired to accurately measure an alternating current while deriving power from the magnetic flux generated by the alternating current to be measured. Such applications may include, for example, low power applications for domestic and/or office electrical power systems, radio frequency applications for communications equipment (for example, equipment in remote and/or difficult to access locations such as cell towers), and/or surveillance applications.

Figs 4A-4C are a perspective diagrams illustrating various details of an exemplary sensing coil 320. Fig. 4A shows the separate layers that comprise laminate core 340 that serves as the core for sensing coil 320. Laminate core 340 may include a plurality of metal layers insulated from each other using a coating to reduce eddy currents. The metal layers may be iron or iron alloys that may include Nickle, Molybdenum, and/or other suitable elements. The coating on each metal layer may include a dielectric material such as printed circuit board (PCB) materials, such as, for example, mixtures of resins and fibrous material, epoxy, etc.

The sensing coil 320, shown without laminate core 340 in Fig. 4B, may comprise a number of windings and a wire material that facilitates the generation of a measurement voltage that can accurately characterize parameters measuring the power line current. Such parameters may include, for example, the amplitude and/or a flow direction of the power line current. The material sensing coil 320 may typically be a solid wire for lower frequency applications, or if higher frequencies are encountered, individually insulated braided wire may be used (e.g., so called "litz" wire) to reduce skin effects. The wire may typically be made from copper wire (or alloys thereof) for its high conductivity, but also may be formed using aluminum (or alloys thereof) in applications where weight and/or cost may be a concern. The wire comprising the winding may be insulated to prevent short circuits in the sensing coil, wherein, for example, the insulation material may be an enamel coating.

Fig. 4C shows an embodiment of sensing coil 320 and laminate core 340 in an assembled configuration that includes non-conductive insulated ends (or edges) 410. Insulated ends 420 are the contact points where laminate core 340 contacts laminate structure 330, and thus may serve to provide electrical isolation for sensing coil 320 to improve its measurement accuracy. Alternatively or additionally, portions of surfaces of laminate structure 330 that come in physical contact with laminate core 340 may also be coated with or fabricated from a non-conductive (insulating) material.

Fig. 5 is a perspective diagram illustrating an embodiment of a coil assembly module 500 in relation to a power line 510. Coil assembly module 500 may include a housing 520 that may completely enclose power coil 310, sensing coil 320, and laminate core 340. Housing 520 may further include additional components of FCI 200 as described above in relation to Fig. 2, or may attach to another module (not shown) to interface with other components of FCI 200. Housing 520 may only partially enclose laminate structure 330 so that power line 510 is positioned so both sensing coil 320 and power coil 310 are sufficiently exposed to the magnetic field produced by the power line current. Housing 520 may be filled, either partially or entirely, with a potting material to physically secure sensing coil 320 and/or power coil 310 and/or prevent vibration.

Laminate structure 330 may at least partially confine power line 510 in the dimension transverse to the direction of current flow. In an embodiment, laminate structure 330 may be a substantially "U" shaped structure that is partially enclosed by the housing at the fixed end, and having an open end protruding from the housing for receiving the power line as illustrated in Fig. 5. Optionally, a thermal sensor 530 may be placed proximately to sensing coil 320 to accurately measure the temperature thereof. Thermal sensor 530 may be placed within entirely within housing 520, or may extend partially outside of housing 520 as shown in Fig. 5.

Fig. 6 is a perspective diagram illustrating another embodiment of a coil assembly 600 that includes a hinged laminate member 610. Coil assembly 600 may comprise housing 520 that may completely enclose power coil 310, sensing coil 320, and laminate core 340. Laminate structure 330 may be a substantially "U" shaped structure that is partially enclosed by the housing at the fixed end, and having an open end protruding from the housing for receiving the power line. Hinged laminate member 610 may be pivotally coupled to one of the open ends of the "U" shaped laminate structure 330, such that hinged laminate member 610 may close the open end of "U" shaped laminate structure 330 to fully confine power line 510 after being received by the "U" shaped structure.

In other embodiments, sensing coil 320 may not be enclosed in housing 520, but instead may be wound around hinged laminate member 610. In such an arrangement (not shown in Fig. 6), sensing coil 320 and power coil 310 may be placed on opposite sides of power line 510 in order to reduce electrical and/or magnetic interactions between the coils.

Fig. 7 is a flow chart showing an exemplary process for monitoring a current flow within a power line according to an embodiment. FCI 220 may initially receive a magnetic field generated by a current flowing through power line 510 (Block 710). The magnetic field may be received by both sensing coil 320 and power coil 310. Sensing coil 320 may generate a measurement voltage induced by the received magnetic field (Block 720). Power coil 310 may generate a supply voltage induced by the received magnetic field (Block 730). A representation of the measurement voltage may be represented in a signal provided to detector/controller 235. Detector/controller 235 may determine measurements of the current flowing through power line 510 based on the measurement voltage (Block 740), and then identify variations in the determined measurements of current (Block 750). Detector/controller 235 may then determine whether the identified variations are indicative of a fault condition (Block 760). Upon determining that the identified variations are indicative of the fault condition, detector/controller 235 may then provide a warning signal to fault alert module 255.

The foregoing description of exemplary implementations provides illustration and description, but is not intended to be exhaustive or to limit the embodiments described herein to the precise form disclosed. Modifications and variations are possible in light of the above teachings or may be acquired from practice of the embodiments. For example, while the series of blocks have been described with respect to Fig. 7, the order of blocks may be modified in other embodiments. Further, non-dependent blocks may be performed in parallel.

Certain features described above may be implemented as "logic" or a "unit" that performs one or more functions. This logic or unit may include hardware, such as one or more processors, microprocessors, application specific integrated circuits, or field programmable gate arrays, software, or a combination of hardware and software.

Although the invention has been described in detail above, it is expressly understood that it will be apparent to persons skilled in the relevant art that the invention may be modified without departing from the spirit of the invention. Various changes of form, design, or arrangement may be made to the invention without departing from the spirit and scope of the invention. Therefore, the above-mentioned description is to be considered exemplary, rather than limiting, and the true scope of the invention is that defined in the following claims.

The terms "comprises" and/or "comprising," as used herein specify the presence of stated features, integers, steps or components but does not preclude the presence or addition of one or more other features, integers, steps, components, or groups thereof. Further, the term "exemplary" (e.g., "exemplary embodiment," "exemplary configuration," etc.) means "as an example" and does not mean "preferred," "best," or likewise.

No element, act, or instruction used in the description of the present application should be construed as critical or essential to the invention unless explicitly described as such. Also, as used herein, the article "a" is intended to include one or more items. Further, the phrase "based on" is intended to mean "based, at least in part, on" unless explicitly stated otherwise.

## Claims

1. A faulted circuit indicator (FCI) device, comprising:
a fault alert module;
a sensor configured to measure a current flowing within a power line based on a first inductive coupling with the power line;
a power supply configured to provide at least one supply voltage based on a second inductive coupling with the power line; and
a detector/controller module coupled to the fault alert module, sensor, and power supply, wherein the detector/controller module is configured to monitor measurements provided by the sensor and provide a warning signal to the fault alert module when a fault condition in the power line is detected.

2. The device of claim 1, wherein the detector/controller module further comprises:
a memory configured to store instructions; and
a processor, coupled to the memory, configured to execute the instructions stored in the memory to:
receive, from the sensor, measurements of current flowing through the power line,
identify variations in the received measurements of current,
determine whether the identified variations are indicative of a fault condition, and
provide a warning signal upon determining that the identified variations are indicative of the fault condition.

3. The device of claim 1 or claim 2, wherein the fault alert module comprises:
at least one on-board fault indicator or a wireless communications interface, wherein the on-board fault indicator further comprises a visual fault indicator comprising at least one of a mechanical flag or a light indicator.

4. The device of any one of claims 1 to 3, wherein the power supply comprises a power coil, arranged around a first laminate core, to generate a primary supply voltage upon exposure to a magnetic field produced by the current flowing through the power line.

5. The device of claim 4, wherein the sensor comprises a sensing coil, arranged around a second laminate core, to generate a measurement voltage upon exposure to the magnetic field produced by the current flowing through the power line.

6. The device of claim 5, wherein the second laminate core is electrically isolated from the first laminate core.

7. The device of claim 6, wherein the second laminate core comprises insulation at contact points with the first laminate core to provide the electrical isolation.

8. The device of any one of claims 5 to 7, wherein
the power coil comprises a first plurality of windings of wire around the first laminate core, wherein the first plurality of windings is greater than 10,000, and
the sensing coil comprises a second plurality of windings of wire around the second laminate core, wherein the second plurality of windings greater than 100.

9. The device of any one of claims 5 to 8, further comprising:
a thermal sensor, proximate to the sensing coil, configured to provide temperature values for compensating the measurement voltage, wherein the measurement voltage characterizes at least one of an amplitude or a flow direction of the current flowing through the power line.

10. The device of any one of claims 5 to 9, wherein the sensing coil is proximally located to the power line, and further wherein the power coil is distally located to the power line.

11. The device of any one of claims 5 to 10, wherein the measurement voltage characterizes at least one of an amplitude or a flow direction of the current flowing through the power line.

12. The device of any one of claims 5 to 11, wherein
the first laminate core comprises a laminate structure configured to at least partially confine the power line in a dimension transverse to a direction of current flow therein, and
the second laminate core further comprises non-conductive edges serving as contact points with the laminate structure,
and the device further comprises:
a housing fixed to the laminate structure and configured to enclose the power coil and the sensing coil.

13. The device of claim 12, further comprising:
a hinged laminate member pivotally configured to close an open end of a "U" shaped structure to fully confine the power line after being received by the "U" shaped structure.

14. The device of claim 12, wherein the laminate structure further comprises a substantially "U" shaped structure that is partially enclosed by the housing at a fixed end, and having an open end protruding from the housing for receiving the power line.

15. A method for monitoring a current flowing within a power line, comprising:
receiving a magnetic field generated by a current flowing through a power line;
generating, at a sensing coil, a measurement voltage induced by the received magnetic field;
generating, at a power coil, a supply voltage induced by the received magnetic field;
determining measurements of the current flowing through the power line based on the measurement voltage;
identifying variations in the determined measurements of current;
determining whether the identified variations are indicative of a fault condition; and
providing a warning signal upon determining that the identified variations are indicative of the fault condition.
